# EUROPEAN PATENT SPECIFICATION

(11) **EP 1 855 378 B1**
(45) Date of publication and mention of the grant of the patent: **14.10.2009**
(21) Application number: 07107570.9
(22) Date of filing: 04.05.2007
(51) Int. Cl.: H03D 7/16

(54) **Quadrature sub-harmonic frequency up-converter and down-converter**
Aufwärtswandler und Abwärtswandler für eine subharmonische Quadraturfrequenz
Convertisseur élévateur et convertisseur à la baisse de fréquences sous-harmoniques de quadrature

(30) Priority: 11.05.2006 US 431972; 11.05.2006 US 432091
(43) Date of publication of application: 14.11.2007
(73) Proprietor: Cobham Defense Electronic Systems Corporation, Bolton MA 01740 (US)
(72) Inventor: Carrez, Frederic, Lexington, MA 02421 (US)
(74) Representative: Bankes, Stephen Charles Digby

(56) References cited:
- EP-A- 1 278 301
- US-A1- 2003 143 966
- US-A1- 2004 063 419
- US-A1- 2004 121 751
- US-B1- 6 282 413
- US-B1- 6 370 372

## Description

The invention pertains to radar and wireless communications systems, such as cellular telephone communications systems and television and radio communications systems.

Generally, in any type of wireless communication system, baseband voice or data signals are carried on a radio frequency (RF) carrier frequency. Thus, circuitry must be provided in a transmitter that places the baseband signal on the RF carrier signal. This process is commonly termed frequency up-conversion and the circuitry that performs this process is commonly called a frequency up-converter. Likewise, in the receiver, the baseband signal must be extracted from the incoming RF receive signal picked up by the receive antenna. This process is commonly termed frequency down-conversion and the circuitry that performs this process is commonly called a frequency down-converter.

There are several techniques in common use for performing frequency up-conversion and frequency down-conversion. One such technique is heterodyning. In heterodyning, the conversion between the RF frequency F_{RF} and the baseband frequency F_{BB} (in either direction) is conducted in two steps. That is, taking frequency down-conversion as an example, the received RF signal is first mixed with a first local oscillator (LO₁) signal having a fixed frequency F_{LO1} spaced relatively far away from the RF carrier frequency, e.g., ½ the RF carrier frequency. When two signals such as the RF signal and the LO₁ signal are mixed, it produces signals at sideband frequencies of F_{RF}-F_{LO1} and F_{RF}+F_{LO1}. The output of the mixer is filtered to eliminate the F_{RF}+F_{LO1} sideband. The remaining signal at the F_{RF}-F_{LO1} side band is herein termed the intermediate frequency or IF signal at frequency F_{IF}. That signal is then introduced into a second mixer in which it is mixed with a second local oscillator signal (LO₂) having the same frequency as the center frequency of the IF signal, namely, F_{LO2} = F_{IF}. Accordingly, the output of the second mixer has a center frequency of F_{IF}-F_{L02}. Since, as noted above, F_{IF} and F_{LO2} have the same frequency, F_{IF}-F_{LO2} = 0 Hz, i.e., the center frequency of the output of this second mixer is at DC (or 0 Hz). Accordingly, the signal output from this second mixer is at baseband, i.e., only the baseband data signal remains. The baseband signal is then, of course, provided to signal processing circuitry for extracting the data from it.

One of the disadvantages of the heterodyning technique is that it requires two local oscillators and their incumbent circuitry, expense, and complexity.

Thus, it is common today to perform frequency down-conversion from the RF frequency to the baseband in a single step. These techniques are called direct conversion techniques. Direct conversion techniques generally fall into two categories, namely, zero-IF and low-IF techniques.

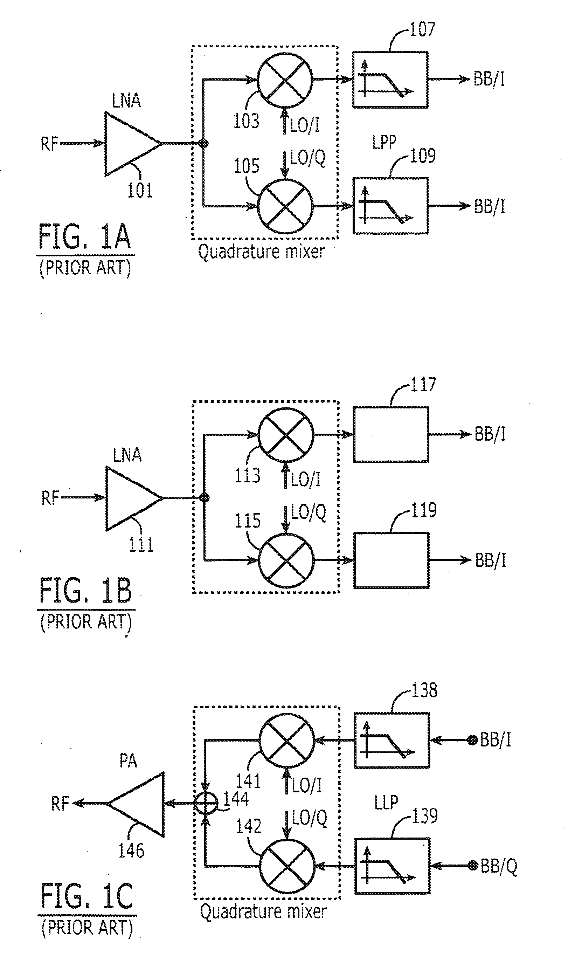

Figure 1A is a block diagram illustrating a zero-IF direct frequency down-converter. In this technique, the RF signal is input to a low noise amplifier 101 in order to produce an amplified RF signal. The amplified RF signal is split into two. One branch is fed to a first mixer 103 that mixes it with a local oscillator signal, the local oscillator signal being equal in frequency to the center frequency of the RF signal. The other branch is fed to a second mixer 105 that mixes it with a second local oscillator signal having the same frequency as the first local oscillator signal, but 90° out of phase with it. The outputs of the two mixers 103 and 105 are each passed through low pass filters 107 and 109, respectively, to produce two baseband signals centered at DC and 90° out of phase with each other in order to reject the image frequency at the input of the receiver.

Figure 1B is a block diagram illustrating a low-IF frequency down-converter for comparison. This technique is similar to the zero-IF technique described above, except that the ultimate output actually is not at DC, but instead is slightly displaced from 0 Hz (e.g., a few MHz) in order to avoid problems associated with DC offset at the output of the mixers and also to eliminate low frequency noise issues. In this technique, the RF signal is input to a low noise amplifier 111 in order to produce an amplified RF signal. The amplified RF signal is split into two. One branch is fed to a first mixer 113 that mixes it with a local oscillator signal, the local oscillator signal being offset slightly in frequency (e.g., a few MHz) from the center frequency of the RF signal. The other branch is fed to a second mixer 115 that mixes it with a second local oscillator signal having the same frequency as the first local oscillator signal, but 90° out of phase with it. The outputs of the two mixers 113 and 115 are each passed through band pass filters 117 and 119, respectively, to produce two baseband signals at a relatively low frequency (e.g., a few MHz) and 90° out of phase with each other.

The steps of zero-IF and low-IF frequency up-conversion are essentially the opposite of those described for zero-IF and low-IF frequency down-conversion.

Figure 1C is a block diagram of an exemplary zero-IF quadrature direct frequency up-converter. A quadrature baseband signal comprising two components BB_{I} and BB_{Q} are first fed through first and second low pass filters 138, 139. The outputs of the low pass filters are fed to first and second mixers 141, 142, respectively, where they are mixed with the two quadrature components LO_{I} and LO_{Q} of a quadrature local oscillator signal. The frequency of the local oscillator signal is the desired RF transmission frequency. The output of the two mixers 141, 142 are combined in an adder 144. The output of the adder 144 is fed to an amplifier 146. The output of the amplifier 146 is the RF signal forwarded to the antenna for transmission.

The advantages of both zero-IF and low-IF direct conversion is that they require only a single local oscillator having two different phases, rather than two local oscillators at different frequencies. A significant disadvantage of direct conversion, however, is the need for a local oscillator that oscillates all the way up at the F_{RF} frequency (or very close to it, in the case of a low-IF technique). Generally, the higher the frequency at which a circuit must operate, the more complex, power-hungry, and expensive that circuit tends to be.

Sub-harmonic mixers also are known in the prior art. In conventional sub-harmonic mixers, the incoming RF signal is mixed with a local oscillator signal having a very high amplitude relative to the amplitude of the incoming RF signal in order to produce non-linearities. Due to the presence of those non-linearities, the sub-harmonic mixer produces output signals not only at the difference between the local oscillator signal and the incoming RF signal (F_{LO}-F_{RF}), but also at harmonics thereof, such as 2F_{LO}-F_{RF}. Accordingly, by using a sub-harmonic mixer, one may utilize a local oscillator that oscillates at a much lower frequency than the RF signal center frequency and still produce signals at baseband or any desired IF band. For instance, let us assume that it is desired to produce an intermediate frequency signal at 8 GHz from a received RF signal at 24 GHz. Using the principles of sub-harmonic mixing, one can employ a sub-harmonic mixer to mix the RF signal with a local oscillator signal at 8 GHz to produce an output having a sideband component at 8 GHz. Particularly, 8 GHz is 2F_{LO}-F_{RF}. On the other hand, if one used a more conventional mixer, it would require a local oscillator operating at 16 GHz to produce an output signal having a frequency component at 8 GHz (i.e., 24 GHz - 16 GHz = 8 GHz).

There are wireless communications systems in use today and/or in development that transmit at frequencies of 10 GHz or even 24 GHz or higher. Accordingly, direct frequency up-conversion and down-conversion in connection with these signals would require very high frequency (and therefore very complex, very expensive, and very power-hungry) local oscillators and phase locked loops (PLLs).

US patent 6282413 discloses a frequency conversion circuit having a first frequency conversion stage with a first mixer, a second conversion stage with a second mixer, an oscillator, a first frequency divider, and a second frequency divider. The first frequency divider is directly connected between the oscillator and an input of the first mixer. The second frequency divider is coupled between the oscillator and an input of the second mixer.

US patent application 2003143966A1 discloses a mixer circuit comprising an up conversion unit for modulating a base-band input signal to a RF signal, a down conversion unit for converting an output signal from the up conversion unit to a base-band output signal, mismatch estimating means for determining a mismatch compensation value by which spurious component in an output signal from the down conversion unit is minimized, wherein the spurious component results from mismatch in the up conversion unit, and mismatch compensating means for compensating the mismatch in the up conversion unit by using the mismatch compensation value determined by the mismatch estimating means.

US patent 6370372 discloses a subharmonic mixer that has two switching stages is used to improved mixer gain in a direct downconversion receiver. The first switching stage mixes a received RF signal to an intermediate frequency that is one-half the received RF signal frequency. The second switching stage mixes the intermediate frequency to baseband. By connecting the two switching stages in series, current is reused and harmonic content from the first stage is fed into the second stage thereby improving the mixer gain.

The present invention provides for an apparatus for frequency down-converting and apparatus for frequency down-converting as claimed in any of the accompanying claims.

The invention will now be described by way of example with reference to the accompanying drawings in which:

Figure 1A is a block diagram of an exemplary zero-IF quadrature down-converter circuit of the prior art.

Figure 1B is a block diagram of an exemplary low-IF quadrature down-converter circuit of the prior art.

Figure 1C is a block diagram of an exemplary low-IF quadrature up-converter circuit of the prior art.

Figure 2A is a block diagram of a quadrature sub-harmonic frequency down-converter in accordance with the principles of the present invention.

Figure 2B is a block diagram of another quadrature sub-harmonic frequency down-converter in accordance with the principles of the present invention.

Figure 3 is a graph illustrating the frequency down-conversion steps in accordance with the principles of the present invention.

Figure 4 is a schematic diagram of a quadrature sub-harmonic frequency down-converter in accordance with the principles of the present invention.

Figure 5A is a circuit diagram of a quadrature sub-harmonic frequency down-converter in accordance with one possible implementation of the present invention.

Figure 5B is a schematic diagram of an alternative embodiment of the current to voltage converter circuit in Figure 5A.

Figure 6 is a schematic diagram of a quadrature sub-harmonic frequency up-converter in accordance with the principles of the present invention.

Figure 7 is a circuit diagram of a quadrature sub-harmonic frequency up-converter in accordance with one possible implementation of the present invention.

The present invention pertains to a quadrature sub-harmonic frequency down-converters and up-converters that frequency convert between baseband and and RF in two stages having the advantages of requiring only a single local oscillator frequency much lower than the received RF signal frequency.

The invention uses the two quadrature components of a single local oscillator signal. Using a down-converter as an example, the first stage, the RF signal is mixed with both components of a local oscillator signal (LO) at or about one third the RF frequency in a sub-harmonic mixer using multi-phase LO signals, in this case, two signals in quadrature, to produce an intermediate frequency output signal (IF) having a frequency of twice the local oscillator frequency minus the RF frequency. i.e., 2F_{LO}-F_{RF} = 1/3F_{RF} = F_{IF}. In a second stage, that IF signal is split into two and supplied to a quadrature mixer that mixes the IF signal with the I component of the same local oscillator signal and separately mixes the IF signal with the Q component of the same local oscillator signal to produce a signal at or about baseband comprising an I component and a separate Q component. Particularly, the output has a frequency component at 3F_{LO}-F_{RF} (since F_{IF} = 2F_{LO} - F_{RF}) and since the local oscillator signal LO has a frequency of about one third the center frequency of the received RF signal, 3F_{LO} = F_{RF}. Therefore, 3F_{LO}-F_{RF} = about OH_{Z} or baseband.

This solution permits effective frequency conversion between RF and baseband in two conversion steps, but using only a single local oscillator. Further, that local oscillator oscillates at a lower frequency than the local oscillator of a direct conversion frequency converter. The present invention, therefore, provides a less expensive, less complex, and lower powered frequency converter than conventional frequency converters.

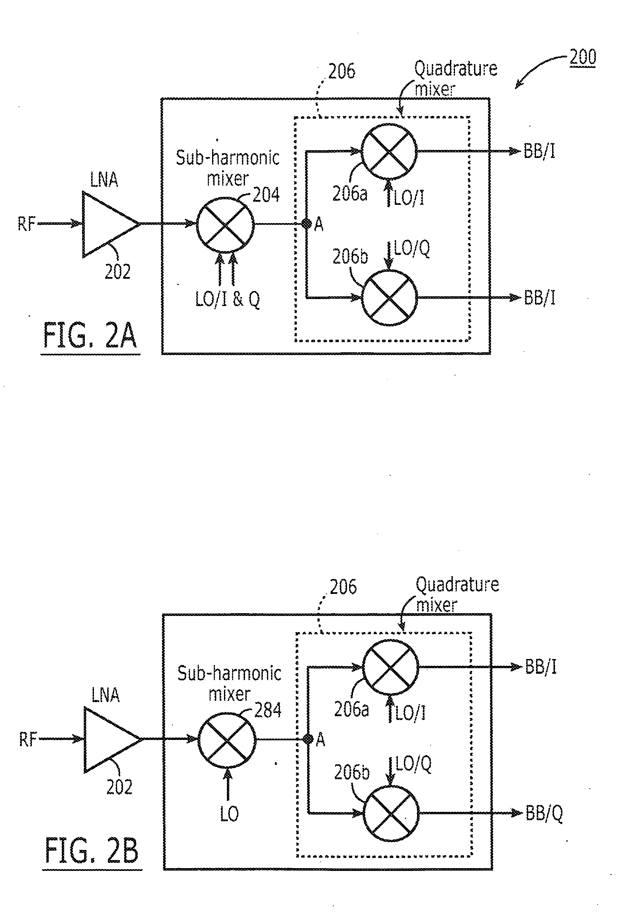

Figure 2A is a block diagram illustrating the basic components of an exemplary frequency down-converter 200 in accordance with the principles of the present invention.

First, a received RF signal from an antenna is amplified in a low noise amplifier 202. The amplified received RF signal is provided to one input of a sub-harmonic mixer 204. Mixer 204 has two other input terminals for receiving two local oscillator signals having the same frequency, but 90° out of phase with each other, i.e., in quadrature. These two signals are hereinafter termed LO_{I} and LO_{Q}. The local oscillator has a frequency, F_{LO}, that is one third the RF signal frequency, F_{RF}. Thus, merely as an example, if the RF signal has a frequency of 24 GHz, the local oscillator needs to generate a signal at only 8 GHz. Hence, the local oscillator can be less complex, lower in cost, and lower in power requirements than in a direct conversion type frequency down-converter, which would require a higher frequency local oscillator. The sub-harmonic mixer 204 uses multi-phase LO signals so that the signal output from the mixer 204 comprises a plurality of harmonic components. Thus, instead of producing the usual sideband components at F_{RF} - F_{LO} and F_{RF} + F_{LO}, it produces sideband frequency components at harmonics, including 2F_{LO} - F_{RF} and 2F_{LO} + F_{RF}. Of interest in the present technique is the harmonic component at 2F_{LO} - F_{RF}, which shall be used as the intermediate frequency or IF signal.

The IF signal output from the sub-harmonic mixer 204 is split into two and fed into a quadrature mixer 206 comprising mixers 206a and 206b. Mixer 206a mixes the IF signal with the LO_{I} component of the local oscillator, while mixer 206b mixes the IF signal with the LO_{Q} component of the local oscillator. This is the same local oscillator used in sub-harmonic mixer 204.

Accordingly, the output of the quadrature mixer 206 comprises two signals that are 90° out of phase with each other and having a frequency component at 3F_{LO}-F_{RF} (since F_{IF} = 2F_{LO} - F_{RF}). Since the local oscillator signal LO has a frequency of one third the center frequency of the received RF signal, 3F_{LO} = F_{RF} or 3F_{LO}-F_{RF} = 0 Hz. Therefore, these two signals are at DC (or baseband).

These two baseband quadrature signals hereinafter termed BB_{I} and BB_{Q}, respectively, comprise the baseband signal that was carried on the original received RF signal. They are forwarded to further signal processing for extracting whatever data is contained in those signals.

Sub-harmonic mixer 204 can be replaced with a non-linear sub-harmonic mixer 284, as illustrated in Figure 2B. All other components remained essentially the same as shown in Figure 2A. Mixer 284 is a different kind of sub-harmonic mixer is then mixer 204 described above in connection with Figure 2B. Instead of mixing the RF signal with both the I and Q components of LO, it mixes the RF signal only with one component of the LO signal, i.e., LO_{I}. However, LO_{I} is amplified to a very high amplitude relative to the amplitude of the RF signal in order to produce non-linearities in the mixer, resulting in the generation of output signals with components at harmonics of F_{LO}-F_{RF}, such as 2F_{LO}-F_{RF}, just as in the Figure 2A embodiment.

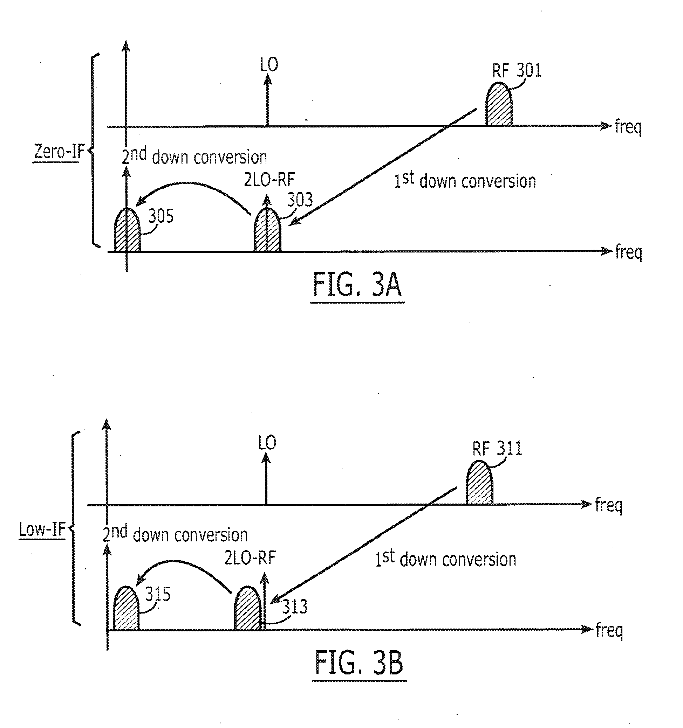

Figure 3A helps illustrate the two frequency conversion steps in accordance with the above-described exemplary embodiment of the invention. As shown at 301, the incoming signal is centered at frequency F_{RF}. The output of the sub-harmonic mixer includes the sideband component of interest 303 centered at frequency 2F_{LO}-F_{RF}. Assuming that the local oscillator signal is at a frequency equal to one third of the RF signal frequency, this intermediate frequency, F_{IF} = 2F_{LO}-F_{RF} = F_{RF}/3. In the second down-conversion step, in which the IF signal 303 at frequency 2F_{LO}-F_{RF} is mixed with the same local oscillator signal at frequency F_{LO}, the signal is further converted down to the baseband signal 305 (0 Hz) since, in this example, F_{LO} = F_{RF}/3 and F_{IF} = F_{RF}/3. Thus, F_{LO} = F_{IF} such that F_{IF}-F_{LO} = 0.

Alternately, if desired, one may construct a sub-harmonic quadrature mixer in accordance with the principles of the present invention to produce a baseband signal that is slightly offset from DC in order to obtain the aforementioned advantages of low-IF down-conversion. This is accomplished by making the local oscillator frequency slightly more or slightly less than one third F_{RF}. The offset from one third F_{RF} should be such that the baseband signal has a frequency low enough that it can be processed by a digital or analog signal processor. Presently, digital processors that can handle data signals at frequencies as high as about 1GHz are known. Accordingly, the offset from F_{RF}/3 may be as much as 333.3 MHz (i.e., one third of 1GHz) and that number will only increase as higher speed and more powerful processors become available. More preferably, however, with currently available processors, the offset from F_{RF}/3 should be kept within about 100MHz or 200MHz.

Figure 3B illustrates the frequency conversion steps for a low-IF embodiment. Particularly, as shown at 311, the incoming signal is at frequency F_{RF}. The sub-harmonic mixer mixes that signal with a local oscillator signal having a frequency slightly offset from F_{RF}/3. In this example, it is slightly higher than F_{RF}/3. Thus, the output of the sub-harmonic mixer includes a component slightly offset from 2F_{LO}-F_{RF}, (i.e., slightly offset from F_{RF}/3), as shown at 313. In the second down-conversion step, in which the IF signal 313 is mixed with the same local oscillator signal at frequency F_{RF}/3, the signal is converted down to a frequency centered slightly higher than DC (0 Hz) as shown at 315.

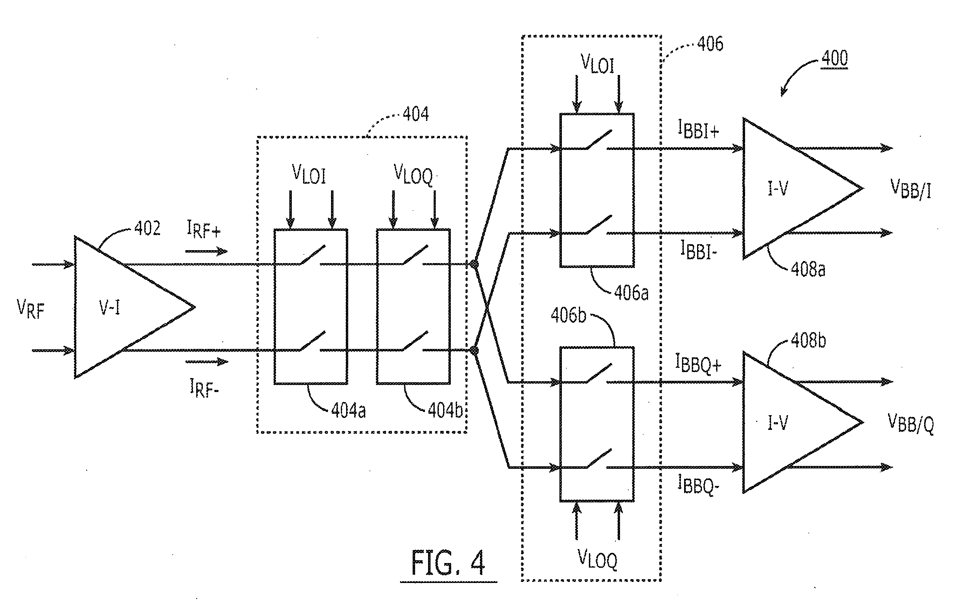

Figure 4 is a more detailed circuit diagram of a quadrature sub-harmonic frequency down-converter in accordance with the principles of the present circuit 400. Figure 4 illustrates a differential embodiment of the circuit 400. Accordingly, the incoming RF voltage signal from the antenna is represented as V_{RF+} and V_{RF-}. The incoming RF voltage signal from the antenna is input to a voltage to current converter 402. It generates two output signals, namely, I_{RF+} and I_{RF-}. These two signals are placed at the inputs of a sub-harmonic converter 404 comprising two switch cells 404a and 404b. Switch cell 404a mixes I_{RF+} and I_{RF-} with the first component of the local oscillator signal, V_{LO/I}, while switch cell 404b mixes the output of switch cell 404a with the second component of the local oscillator signal, V_{LO/Q}, which has the same frequency as V_{LO/I}, but is 90° out of phase with it.

Accordingly, the output of the sub-harmonic mixer 404 comprises a differential signal having a frequency component at 2F_{LO}-F_{RF}. The two components of the differential signal are hereinafter termed IF+ and IF-. Each of the two signals are split in two and fed into the inputs of the quadrature mixer 406. Quadrature mixer 406 comprises two switch cells 406a and 406b. Switch cell 406a mixes the differential signal with V_{LO/I} and switch cell a 406b mixes the differential signal with V_{LO/Q}. Accordingly, the output of the quadrature mixer is the baseband signal carried on the incoming RF signal and comprises four signal lines, namely, BB_{I+}, BB_{I-}, BB_{Q+}, and BB_{Q-}.

These baseband signals are then converted from current to voltage signals by voltage converters 408a and 408b to produce two differential voltage signals 90° out of phase with each other, V_{BB/I} and V_{BB/Q}, each comprising a differential signal. In other words, there are four output signal lines, namely, V_{BB/I+}, V_{BB/I-}, V_{BB/Q+}, and V_{BB/Q-}.

All of the switches are shown schematically in Figure 4 to emphasize the fact that the invention can be implemented in any reasonable technology, including, for example, bipolar, CMOS, BiCMOS, MOSFET, and MESFET.

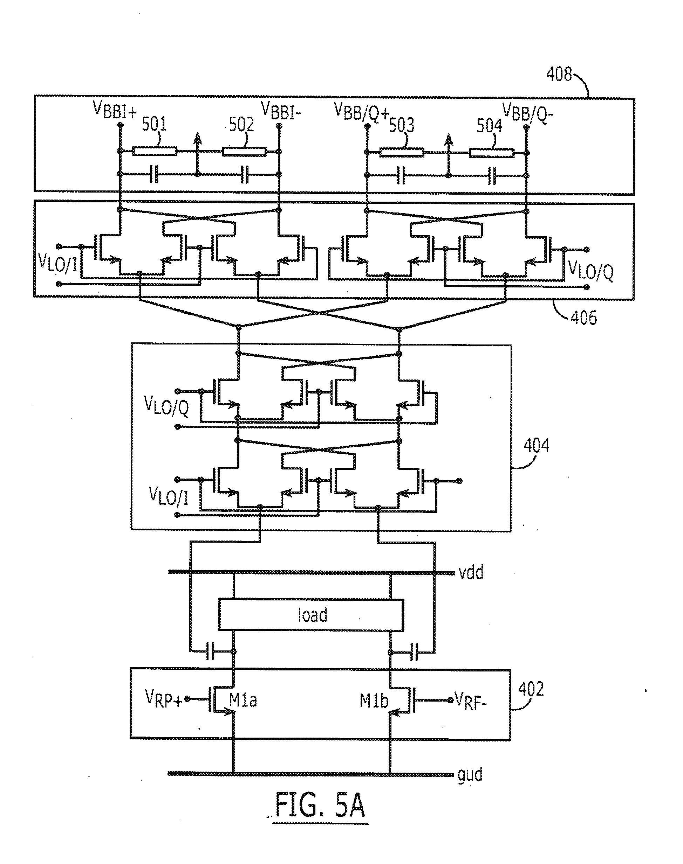

Figure 5A is an exemplary circuit implementation of the sub-harmonic quadrature frequency down-converter shown in Figure 4 implemented in NMOS technology. Particularly, the voltage-to-current converter 402 is implemented as two NMOS transistors MIA and M1B. The current flow terminals of M1A and M1B are coupled between V_{DD} and ground. The gates of those two transistors are coupled to the RF+ and RF- signals, respectively. The sub-harmonic mixer 404 comprises two switch cells 404a and 404b, each implemented by four NMOS transistors, as shown. The quadrature mixer 406, comprising switch cells 406a and 406b as previously described, are implemented using the same transistor design as in the sub-harmonic mixer, namely, each switch comprising four NMOS transistors connected as shown. Finally, the current-to-voltage converter 408 is shown as a passive converter using resistors 501, 502, 503, and 504 to convert the current signals to voltage signals.

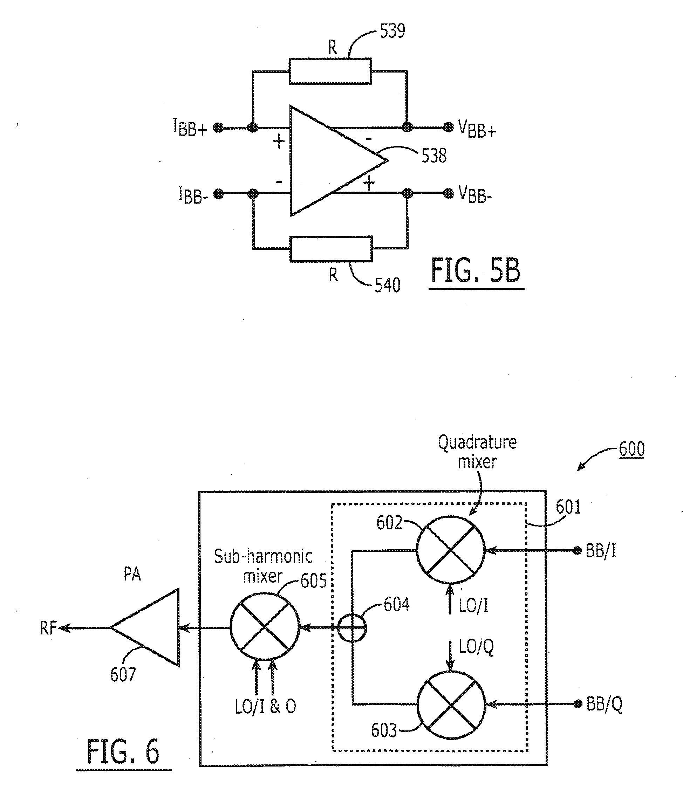

Alternately, the current and voltage converter could be formed of active circuit components such as illustrated in Figure 5B. Particularly, a differential operational amplifier 538 receives I_{BB+} and I_{BB-} at its non-inverting and inverting inputs, respectively. Feedback resistors 539 and 540 are coupled between the inputs and outputs of the operational amplifier 538, as shown.

The technique and apparatus in accordance with the present invention for frequency up converting a baseband signal to the RF transmission signal are essentially the opposite of that described above for the frequency down-conversion process. Figure 6 is a block diagram of a sub-harmonic quadrature frequency up-converter 600 in accordance with the principles of the present invention. As shown, a quadrature baseband signal comprising components BBᵢ and BB_{Q} are fed to inputs of first and second mixers 602 and 603 of quadrature mixer 601, where they are mixed with the quadrature components LO_{I} and LO_{Q} of a quadrature local oscillator. Again, for exemplary purposes, let us assume that the local oscillator has a frequency of one third the desired RF transmission frequency.

The outputs of the mixers 602 and 603 are centered at the frequency of the local oscillator minus the frequency of the baseband signal and at the frequency of the local oscillator plus the frequency of the baseband signal, i.e., F_{LO} ± F_{BB}. Assuming a zero-IF type embodiment of the invention, the center frequency of the baseband signal is 0 Hz. Therefore, we can essentially say that the intermediate frequency F_{IF} of the signals at the outputs of the mixers 602, 603 is F_{LO}-OHz = F_{LO}, which is 1/3 F_{RF}.

The outputs of the two mixers 602, 603 in the quadrature mixer 601 are combined in an adder 604. The output of the adder 604 is fed into one input of a multi-phase sub-harmonic mixer 605. The multi-phase sub-harmonic mixer mixes this combined signal with the same local oscillator signals LOI and LOQ that were used in the quadrature mixer 601. The output of the sub-harmonic mixer 605 comprise components at various harmonics, including, at least, a frequency component at 2F_{LO}+F_{IF}, which alternately may be written as 2F_{LO}+F_{LO}=3F_{LO}= F_{RF} since F_{LO}=F_{IF}= 1/3F_{RF}. The other frequency components contained in the output of the sub-harmonic mixer, such as the harmonic at 2F_{LO}-F_{LO} = F_{LO} can be easily filtered.

The description above is of a zero-IF type embodiment of the invention. In a low-IF type embodiment, these frequencies would instead be 2F_{LO} + F_{LO} ± F_{BB} = 3F_{LO} ± F_{BB}.

The quadrature outputs of the sub-harmonic mixer 605 are fed into a power amplifier 607, where they are amplified. The output of the amplifier 607 is forwarded to the antenna for transmission.

The various filters that would likely be incorporated in the signal paths of frequency up-converter 600 of Figure 6 are not shown in the figure in order not to obfuscate the invention. However, it would be apparent to those of skill in the art that the aforementioned filter for band pass filtering out the frequency components at frequencies other than F_{RF} would appear right before the power amplifier 607. Also, low pass filters likely would be positioned before each of the mixers 602, 603 of the quadrature mixer 601 in order to low pass filter the BB_{I} and BB_{Q} signals.

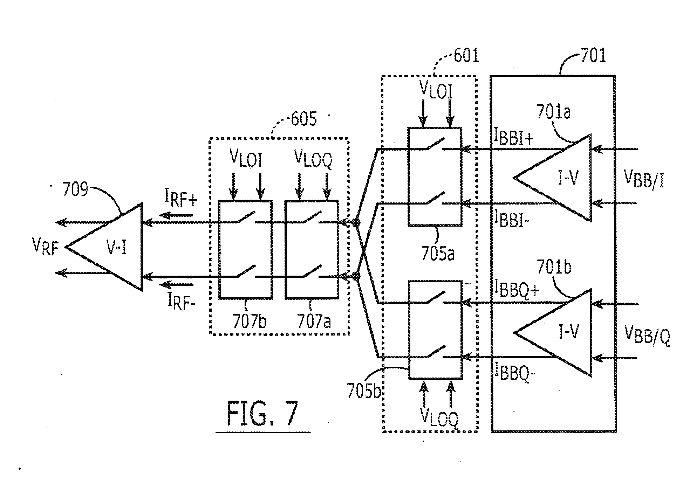

Figure 7 is a more detailed diagram of the frequency up-converter of Figure 6. Figure 7 shows a differential embodiment 700 of the converter.

As shown, baseband input signals V_{BB/I}, V_{BB/Q} are converted in voltage-to-current conversion stage 701 from voltage domain to current domain by voltage-to-current converters 701a, 701b. The four differential quadrature outputs of the voltage-to-current converter stage 700 are passed to the two switch cells 705a, 705b of the quadrature mixer 601. As previously described in connection with Figure 6, the outputs are combined and fed to the sub-harmonic mixer 605. The multi-phase sub-harmonic mixer 605 may comprise two switch cells 707a, 707b where the IF differential signal is mixed with the quadrature local oscillator signals, as previously described in connection with Figure 6. As shown, the multi-phase sub-harmonic mixer comprises two switch cells 707a, 707b coupled in series, one for mixing the combined differential IF signals with the Q component of the local oscillator and then with the I component of the local oscillator signal (or vice versa). The order of the mixing, i.e., whether the IF signal is first mixed with the I component or the Q component of the local oscillator, is irrelevant. Either order is acceptable. The differential outputs of the sub-harmonic mixer are fed to a current-to-voltage converter 709. If amplification is necessary, an amplifier may be positioned after the converter 709 (not shown). The differential output voltage signals at the desired RF output frequency are then fed to the antenna for transmission.

The switch cells 705a, 705b, 707a, 707b can be implemented, for instance, exactly the same as the switch cells used in the exemplary frequency down-converter illustrated in Figure 5.

The frequency up-conversion and frequency down-conversion techniques and apparatus disclosed herein allow very high frequency operation using local oscillator signals at much lower frequency than the RF transmission frequency. The main benefits of this solution include the need for only a single frequency synthesizer for the local oscillator. Furthermore, the synthesizer operates at a much lower frequency than the RF transmission/receive frequency, i.e., 1/3. Additionally, the technique requires only two local oscillator signals at the same frequency and 90° phase shifted from each other to perform both frequency conversion steps. Moreover, the local oscillator signals can be generated more accurately, less costly, and with less power.

The present invention provides a low-power, low-cost solution to the needs of the new high frequency standards for communication or radar applications.

## Claims

1. A frequency down-converter (200) for converting a first data signal centered at a first frequency to a second data signal containing the same data as said first data signal and centered at a second frequency lower than said first frequency comprising:
a local oscillator generating a quadrature signal at a third frequency that is about 1/3 of said first frequency, said quadrature signal having a first component having a first phase and a second component having a second phase 90° out of phase with said first component;
a sub-harmonic mixer (204) coupled to receive said first data signal at a first input terminal thereof and coupled to receive one or both of said first and second components of said local oscillator signal at second or second and third input terminals thereof respectively, said sub-harmonic mixer generating a third data signal having a fourth frequency that is the difference between the first frequency and a harmonic of said third frequency;
a quadrature mixer (206) comprising first and second mixer components (206a, 206b), said first mixer component (206a) coupled to mix said third data signal with said first component of said quadrature local oscillator signal to produce a first component of said second data signal centered at said second frequency and said second mixer component (206b) coupled to mix said third data signal with said second component of said quadrature local oscillator signal to produce a second component of said second data signal centered at said second frequency.

2. The apparatus of claim 1 wherein said first data signal comprises a baseband data signal carried on a radio frequency carrier signal.

3. The apparatus of claim 2 wherein said second data signal is centered at 0 Hz.

4. The apparatus of claim 2 wherein said second data signal is centered at a frequency other than 0 Hz.

5. The apparatus of claim 1 wherein said third frequency is within about 333.3MHz of 1/3 said first frequency.

6. The apparatus of claim 1 further comprising an amplifier (202) coupled between said first data signal and said first input terminal of said sub-harmonic mixer.

7. The apparatus of claim 1 further comprising:
a voltage to current converter (402) coupled between said first data signal and said first input terminal of said sub-harmonic mixer; and
a current to voltage converter (408a, 408b) having an input terminal coupled to said quadrature mixer and an output terminal.

8. A frequency up-converter (600) for converting a first data signal centered at a first frequency to a second data signal containing the same data as said first data signal and centered at a second frequency higher than said first frequency comprising:
an oscillator generating a quadrature signal at a third frequency that about 1/3 of said second frequency, said quadrature signal having a first component having a first phase and a second component having a second phase 90° out of phase with said first component;
a quadrature mixer (601) comprising first and second mixer components (602, 603), said first mixer component (602) coupled to mix said first data signal with said first component of said oscillator signal to produce a first component of a third data signal centered at a fourth frequency and said second mixer component (603) coupled to mix said first data signal with said second component of said oscillator signal to produce a second component of said third data signal centered at said fourth frequency;
a combining circuit (604) coupled to combine said first and second components of said third data signal to produce a combined third data signal;
a sub-harmonic mixer (605) coupled to receive said combined third data signal at a first input terminal thereof and coupled to receive one or both of said first and second components of said oscillator signal at a second or a second and third input terminal thereof respectively, said sub-harmonic mixer generating said second data signal having said second frequency being a harmonic frequency of said third and fourth frequencies.

9. The apparatus of claim 8 wherein said first data signal comprises a baseband data signal carried on a radio frequency carrier signal.

10. The apparatus of claim 9 wherein said first data signal is centered at 0 Hz.

11. The apparatus of claim 9 wherein said first data signal is centered at a frequency other than 0 Hz.

12. The apparatus of claim 8 wherein said third frequency is within about 333.3MHz of 1/3 said second frequency.

13. The apparatus of claim 8 further comprising:
an amplifier (607) coupled to amplify said second data signal.

14. The apparatus of claim 8 further comprising:
a voltage to current converter (701) coupled between said first data signal and said quadrature mixer; and
a current to voltage converter (709) having an input terminal coupled to receive said second data signal and an output terminal.

## Patentansprüche

1. Abwärts-Frequenzumsetzer (200) zum Umwandeln eines ersten Datensignals, das um eine erste Frequenz zentriert ist, in ein zweites Datensignal, das dieselben Daten wie das erste Datensignal enthält und um eine zweite Frequenz zentriert ist, die tiefer als die erste Frequenz ist, umfassend:
einen lokalen Oszillator, der ein Quadratursignal bei einer dritten Frequenz erzeugt, die ungefähr 1/3 der ersten Frequenz beträgt, wobei das Quadratursignal eine erste Komponente, die eine erste Phase hat, und eine zweite Komponente hat, die eine zweite Phase hat, die gegenüber der ersten Komponente um 90° phasenverschoben ist;
einen subharmonischen Mischer (204), der dazu angeschlossen ist, das ersten Datensignal an dessen erstem Eingang zu empfangen, und dazu angeschlossen ist, entweder die erste oder die zweite Komponente des lokalen Oszillatorsignals oder beide an dessen zweitem bzw. zweitem und drittem Eingang zu empfangen, wobei der subharmonische Mischer ein drittes Datensignal erzeugt, das eine vierte Frequenz aufweist, welche die Differenz zwischen der ersten Frequenz und einer Harmonischen der dritten Frequenz ist;
einen Quadraturmischer (206), der eine erste und eine zweite Mischerkomponente (206a, 206b) umfasst, wobei die erste Mischerkomponente (206a) dazu angeschlossen ist, das dritte Datensignal mit der ersten Komponente des lokalen Quadratur-Oszillatorsignals zu mischen, um eine erste Komponente des zweiten Datensignals zu erzeugen, die um die zweite Frequenz zentriert ist, und die zweite Mischerkomponente (206b) dazu angeschlossen ist, das dritte Datensignal mit der zweiten Komponente des lokalen Quadratur-Oszillatorsignals zu mischen, um eine zweite Komponente des zweiten Datensignals zu erzeugen, die um die zweite Frequenz zentriert ist.

2. Vorrichtung nach Anspruch 1, wobei das erste Datensignal ein Basisbanddatensignal umfasst, das auf einem Hochfrequenzträgersignal getragen wird.

3. Vorrichtung nach Anspruch 2, wobei das zweite Datensignal um 0 Hz zentriert ist.

4. Vorrichtung nach Anspruch 2, wobei das zweite Datensignal um eine Frequenz zentriert ist, die nicht 0 Hz ist.

5. Vorrichtung nach Anspruch 1, wobei sich die dritte Frequenz um höchstens ungefähr 333,3 MHz von 1/3 der ersten Frequenz unterscheidet.

6. Vorrichtung nach Anspruch 1, ferner umfassend einen Verstärker (202), der zwischen das erste Datensignal und den ersten Eingang des subharmonischen Mischers geschaltet ist.

7. Vorrichtung nach Anspruch 1, ferner umfassend:
einen Spannungs-Strom-Wandler (402), der zwischen das erste Datensignal und den ersten Eingang des subharmonischen Mischers geschaltet ist; und
einen Strom-Spannungs-Wandler (408a, 408b), der einen Eingang, der mit dem Quadraturmischer verbunden ist, und einem Ausgang aufweist.

8. Aufwärts-Frequenzumsetzer (600) zum Umwandeln eines ersten Datensignals, das um eine erste Frequenz zentriert ist, in ein zweites Datensignal, das dieselben Daten wie das erste Datensignal enthält und um ein zweite Frequenz zentriert ist, die höher als die erste Frequenz ist, umfassend:
einen Oszillator, der ein Quadratursignal bei einer dritten Frequenz erzeugt, die ungefähr 1/3 der zweiten Frequenz beträgt, wobei das Quadratursignal eine erste Komponente, die eine erste Phase hat, und ein zweite Komponente hat, die eine zweite Phase hat, die gegenüber der ersten Komponente um 90° phasenverschoben ist;
einen Quadraturmischer (601), der eine erste und ein zweite Mischerkomponente (602, 603) umfasst, wobei die erste Mischerkomponente (602) dazu angeschlossen ist, das erste Datensignal mit der ersten Komponente des Oszillatorsignals zu mischen, um ein erste Komponente eines dritten Datensignals zu erzeugen, die um eine vierte Frequenz zentriert ist, und wobei die zweite Mischerkomponente (603) dazu angeschlossen ist, das erste Datensignal mit der zweiten Komponente des Oszillatorsignals zu mischen, um eine zweite Komponente des dritten Datensignals zu erzeugen, die um die vierte Frequenz zentriert ist;
eine Kombinationsschaltung (604), die dazu angeschlossen ist, die erste und die zweite Komponente des dritten Datensignals zu kombinieren, um ein kombiniertes drittes Datensignal zu erzeugen;
einen subharmonischen Mischer (605), der dazu angeschlossen ist, das kombinierte dritte Datensignal an dessen erstem Eingang zu empfangen, und der dazu angeschlossen ist, entweder die erste oder die zweite Komponente des Oszillatorsignals oder beide an dessen zweitem bzw. zweitem und drittem Eingang zu empfangen, wobei der subharmonische Mischer das zweite Datensignal erzeugt, das die zweite Frequenz hat, die eine harmonische Frequenz der dritten und der vierten Frequenz ist.

9. Vorrichtung nach Anspruch 8, wobei das erste Datensignal ein Basisbanddatensignal umfasst, das auf einem Hochfrequenzträgersignal getragen wird.

10. Vorrichtung nach Anspruch 9, wobei das zweite Datensignal um 0 Hz zentriert ist.

11. Vorrichtung nach Anspruch 9, wobei das zweite Datensignal um eine Frequenz zentriert ist, die nicht 0 Hz ist.

12. Vorrichtung nach Anspruch 8, wobei sich die dritte Frequenz um höchstens ungefähr 333,3 MHz von 1/3 der zweiten Frequenz unterscheidet.

13. Vorrichtung nach Anspruch 8, ferner umfassend:
einen Verstärker (607), der zum Verstärken des zweiten Datensignals angeschlossen ist.

14. Vorrichtung nach Anspruch 8, ferner umfassend:
einen Spannungs-Strom-Wandler (701), der zwischen das erste Datensignal und den Quadratur-Mischer geschaltet ist; und
einen Strom-Spannungs-Wandler (709), der einen Eingang, der zum Empfangen des zweiten Datensignals geschaltet ist, und einen Ausgang aufweist.

## Revendications

1. Convertisseur abaisseur de fréquence (200) pour convertir un premier signal de données centré à une première fréquence en un deuxième signal de données contenant les mêmes données que ledit premier signal de données et centré à une deuxième fréquence inférieure à ladite première fréquence, comprenant :
un oscillateur local générant un signal en quadrature à une troisième fréquence qui est égale à environ 1/3 de ladite première fréquence, ledit signal en quadrature comportant un première composante ayant une première phase et une deuxième composante ayant une deuxième phase décalée de 90° par rapport à celle de ladite première composante ;
un mélangeur de sous-harmoniques (204) couplé pour recevoir ledit premier signal de données à une première borne d'entrée de celui-ci et couplé pour recevoir l'une desdites première et deuxième composantes, ou les deux, dudit signal d'oscillateur local à une deuxième ou des deuxième et troisième bornes d'entrée de celui-ci, respectivement, ledit mélangeur de sous-harmoniques générant un troisième signal de données ayant une quatrième fréquence qui est égale à la différence entre la première fréquence et une harmonique de ladite troisième fréquence ;
un mélangeur en quadrature (206) comprenant des premier et deuxième composants de mélangeur (206a, 206b), ledit premier composant de mélangeur (206a) étant couplé pour mélanger ledit troisième signal de données avec ladite première composante dudit signal d'oscillateur local en quadrature pour produire une première composante dudit deuxième signal de données centré à ladite deuxième fréquence et ledit deuxième composant de mélangeur (206b) étant couplé pour mélanger ledit troisième signal de données avec ladite deuxième composante dudit signal d'oscillateur local en quadrature pour produire une deuxième composante dudit deuxième signal de données centré à ladite deuxième fréquence.

2. Dispositif selon la revendication 1, dans lequel ledit premier signal de données comprend un signal de données de bande de base porté par un signal de porteuse radiofréquence.

3. Dispositif selon la revendication 2, dans lequel ledit deuxième signal de données est centré à 0 Hz.

4. Dispositif selon la revendication 2, dans lequel ledit deuxième signal de données est centré à une fréquence différente de 0 Hz.

5. Dispositif selon la revendication 1, dans lequel ladite troisième fréquence est dans les limites d'environ 333,3 MHz autour du 1/3 de ladite première fréquence.

6. Dispositif selon la revendication 1, comprenant en outre un amplificateur (202) couplé entre ledit premier signal de données et ladite première borne d'entrée dudit mélangeur de sous-harmoniques.

7. Dispositif selon la revendication 1, comprenant en outre :
un convertisseur tension-courant (402) couplé entre ledit premier signal de données et ladite première borne d'entrée dudit mélangeur de sous-harmoniques ; et
un convertisseur courant-tension (408a, 408b) ayant une borne d'entrée couplée audit mélangeur en quadrature et une borne de sortie.

8. Convertisseur élévateur de fréquence (600) pour convertir un premier signal de données centré à une première fréquence en un deuxième signal de données contenant les mêmes données que ledit premier signal de données et centré à une deuxième fréquence supérieure à ladite première fréquence, comprenant :
un oscillateur générant un signal en quadrature à une troisième fréquence qui est égale à environ 1/3 de ladite deuxième fréquence, ledit signal en quadrature ayant une première composante ayant une première phase et une deuxième composante ayant une deuxième phase décalée de 90° par rapport à celle de ladite première composante ;
un mélangeur en quadrature (601) comprenant des premier et deuxième composants de mélangeur (602, 603), ledit premier composant de mélangeur (602) étant couplé pour mélanger ledit premier signal de données avec ladite première composante dudit signal d'oscillateur pour produire une première composante d'un troisième signal de données centré à une quatrième fréquence et ledit deuxième composant de mélangeur (603) étant couplé pour mélanger ledit premier signal de données avec ladite deuxième composante dudit signal d'oscillateur pour produire une deuxième composante dudit troisième signal de données centré à ladite quatrième fréquence ;
un circuit combineur (604) couplé pour combiner lesdites première et deuxième composantes dudit troisième signal de données pour produire un troisième signal de données combiné ;
un mélangeur de sous-harmoniques (605) couplé pour recevoir ledit troisième signal de données combiné à une première borne d'entrée de celui-ci et couplé pour recevoir l'une desdites première et deuxième composantes, ou les deux, dudit signal d'oscillateur à une deuxième ou des deuxième et troisième bornes d'entrée de celui-ci, respectivement, ledit mélangeur de sous-harmoniques générant ledit deuxième signal de données ayant ladite deuxième fréquence qui est une fréquence harmonique desdites troisième et quatrième fréquences.

9. Dispositif selon la revendication 8, dans lequel ledit premier signal de données comprend un signal de données de bande de base porté par un signal de porteuse radiofréquence.

10. Dispositif selon la revendication 9, dans lequel ledit premier signal de données est centré à 0 Hz.

11. Dispositif selon la revendication 9, dans lequel ledit premier signal de données est centré à une fréquence différente de 0 Hz.

12. Dispositif selon la revendication 8, dans lequel ladite troisième fréquence est dans les limites d'environ 333,3 MHz autour du 1/3 de ladite deuxième fréquence.

13. Dispositif selon la revendication 8, comprenant en outre :
un amplificateur (607) couplé pour amplifier ledit deuxième signal de données.

14. Dispositif selon la revendication 8, comprenant en outre :
un convertisseur tension-courant (701) couplé entre ledit premier signal de données et ledit mélangeur en quadrature ; et
un convertisseur courant-tension (709) ayant une borne d'entrée couplée pour recevoir ledit deuxième signal de données et une borne de sortie.
